# EUROPEAN PATENT SPECIFICATION

(11) **EP 3 368 943 B1**
(45) Date of publication and mention of the grant of the patent: **28.07.2021**
(21) Application number: 16859188.1
(22) Date of filing: 31.10.2016
(51) Int. Cl.: G02F 1/1347, G09G 3/00

(54) **METHOD AND SYSTEM FOR PERFORMING PANEL VIBRATION AND SELECTIVE BACKLIGHT CONTROL TO REDUCE MOIRÉ INTERFERENCE IN A DISPLAY SYSTEM INCLUDING MULTIPLE DISPLAYS**
VERFAHREN UND SYSTEM ZUR DURCHFÜHRUNG VON TAFELSCHWINGUNGS- UND SELEKTIVER HINTERGRUNDBELEUCHTUNGSSTEUERUNG ZUR REDUZIERUNG VON MOIRÉ-INTERFERENZEN BEI EINEM ANZEIGESYSTEM MIT MEHREREN ANZEIGEN
PROCÉDÉ ET SYSTÈME PERMETTANT D'EFFECTUER UNE COMMANDE DE VIBRATION ET DE RÉTROÉCLAIRAGE SÉLECTIF DE PANNEAU POUR RÉDUIRE UNE INTERFÉRENCE DE MOIRÉ DANS UN SYSTÈME D'AFFICHAGE COMPRENANT DE MULTIPLES AFFICHEURS

(30) Priority: 30.10.2015 US 201562248973 P
(43) Date of publication of application: 05.09.2018
(73) Proprietor: Aptiv Technologies Limited, St. Michael (BB)
(72) Inventor: BELL, Gareth, Auckland (NZ); SINGH, Darryl, Auckland 1061 (NZ); NEWTON, John D., Auckland 1071 (NZ)
(74) Representative: Manitz Finsterwald Patent- und Rechtsanwaltspartnerschaft mbB
(86) International application number: PCT/IB2016/056562
(87) International publication number: WO 2017/072742

(56) References cited:
- JP-A- 2005 128 195
- US-A1- 2003 222 857
- US-A1- 2013 316 814
- US-A1- 2013 316 814
- US-A1- 2015 310 798
- US-A1- 2015 310 798
- US-B2- 8 832 574

## Description

This application is related to and claims priority on prior provisional U.S. Patent Application No. 62/248,973, filed October 30, 2015 (Our Ref. 6468-4).

### FIELD OF THE INVENTION

This invention relates to a multi-display system (e.g., a display including multiple display panels), where at least first and second displays (e.g., display panels or display layers) are arranged substantially parallel to each other in order to display three-dimensional (3D) features to a viewer(s). Thus, this invention relates generally to displays and, more particularly, to display systems and methods for displaying three-dimensional features. Panel vibration (e.g., lateral vibration) and selective backlight control are used to reduce moire interference in order to improve image quality to viewer(s).

### BACKGROUND AND SUMMARY OF THE INVENTION

Traditionally, displays present information in two dimensions. Images displayed by such displays are planar images that lack depth information. Because people observe the world in three-dimensions, there have been efforts to provide displays that can display objects in three-dimensions. For example, stereo displays convey depth information by displaying offset images that are displayed separately to the left and right eye. When an observer views these planar images they are combined in the brain to give a perception of depth. However, such systems are complex and require increased resolution and processor computation power to provide a realistic perception of the displayed objects.

Multi-component displays including multiple display screens in a stacked arrangement have been developed to display real depth. Each display screen may display its own image to provide visual depth due to the physical displacement of the display screens. For example, multi-display systems are disclosed in U.S. Patent Publication Nos. 2015/0323805 and 2016/0012630. US 2013/316814 A1 and JP 2005 128195 A disclose a display device and a method in accordance with the preambles of the independent claims.

When a first and second displays or display layers are conventionally stacked on each other in a multi-display system, undesirable moire interference occurs. The moire interference is caused by interactions between the color filters within the layers when projected onto the viewer's retina. For example, when green color filters overlap, light is transmitted making for a comparative bright patch. When a green filter is over say a red filter, not as much light will be transmitted making for a dark region. Since the rear and front displays or display layers have slightly different sizes when projected onto the retina, the pixels will slowly change from being in phase to out of phase. This has the effect of producing dark and bright bands otherwise known as moire interference.

There have been several approaches to removing moire interference in a multi-layer display (MLD) system. Some approaches rely on removing unwanted frequency components by spatial filtering. This can be accomplished with either a diffuser type system whereby an element with a refractive index of about 1.5 has random surface perturbations, or a diffraction type system. The performance of these systems in terms of visual aesthetics (e.g., how blurry the image looks; how much residual moire is left; the effect on polarization; and cost, etc.) depend greatly on the system configuration. Certain MLD systems solely utilize diffusive optics to blur the rear-most display layer. This approach suffers from the following limitations: (a) the diffusing element utilizes a specialized diffuser pattern, which is difficult to obtain; (b) the diffusing element sits between polarizers and both the film substrate and stiffener substrate must be free of any birefringence; and (c) the diffusing element requires a separate stiffener component (usually glass) which adds weight and expense to the final display system. As a result, MLD systems using solely a diffuser to address moire issues do not provide an ideal solution to reducing moire interference, especially as those systems have reduced form factors.

Historic and present methodologies that rely only on diffusers to address moire interference do not provide an acceptable solution to the moire issue without the introduction of significant and detrimental side-effects to image quality.

The invention is defined by the independent claims. Certain example embodiments of the instant invention provide solution(s) that make moire interference in MLD systems vanish or substantially vanish. In the example embodiments of this invention, the MLD system includes first and second displays. Panel vibration (e.g., lateral vibration) and selective backlight control are used to reduce moiré interference in order to improve image quality to viewer(s). In an example embodiment of this invention, only one of the two display panels in the MLD system is vibrated in order to blur out, or substantially blur, color filters instead of having to rely solely on a diffuser or the like. Such moire interference reduction techniques (panel vibration and backlight control) may or may not be used in combination with other moire reducing techniques such as diffuser(s) and/or refractive element(s) according to various embodiments of this invention.

According to a first aspect of this invention, there is provided a display device as defined in claim 1.

According to a second aspect of this invention, there is provided a method for displaying images via a display apparatus as defined in claim 11.

### BRIEF DESCRIPTION OF THE DRAWINGS

These and other features and advantages may be better and more completely understood by reference to the following detailed description of exemplary illustrative embodiments in conjunction with the drawings, of which:
FIGURE 1 is a side cross sectional view of a MLD system including first and second displays stacked on each other according to an example embodiment of this invention;
FIGURE 2 is a schematic side cross sectional view illustrating a MLD system including first and second displays stacked on each other according to an example embodiment of this invention;
FIGURE 3 is a top view illustrating on the left a panel with no vibration, and on the right a panel being vibrated, in order to reduce moire interference in the MLD system of any embodiment herein; and
FIGURE 4 is a timing diagram illustrating selective backlight control in order to reduce moire interference according to an example embodiment of this invention that may be used in combination with any and/or all of Figs. 1-3.

### DETAILED DESCRIPTION

This invention relates to a multi-display system (e.g., a display including multiple display panels), where at least first and second displays (e.g., display panels or display layers) are arranged substantially parallel to each other in order to display three-dimensional (3D) features to a viewer(s). The displays may be flat or curved in different embodiments. Thus, embodiments of this invention relate generally to displays and, more particularly, to display systems and methods for displaying three-dimensional features. MLDs according to example embodiments of this invention may be used, for example, as displays in vehicle dashes in order to provide 3D images (e.g., for speedometers, vehicle gauges, vehicle navigation displays, etc.).

The color moiré interference problem is caused for example by pattern regularity of both LCD color filter arrays as the RGB pixels are aligned into RGB columns. Color moiré interference is largely prevalent in the horizontal direction.

Certain example embodiments of the instant invention provide solution(s) that make moiré interference in MLD systems vanish or substantially vanish. In the example embodiments of this invention, the MLD system includes at least first and second displays that are provided in a stacked relationship so as to be located on different respective planes that are parallel or substantially parallel to each other. In the example embodiments of this invention, the MLD system includes first and second displays. Panel vibration (e.g., lateral vibration such as introduction of Perlin noise) and selective backlight control are used to reduce moire interference in order to improve image quality to viewer(s). In an example embodiment of this invention, only one of the two display panels in the MLD system is vibrated in order to blur out, or substantially blur, color filters instead of having to rely solely on a diffuser or the like. The other panel is not vibrated. Such moire interference reduction techniques (panel vibration and backlight control) may or may not be used in combination with other moire reducing techniques such as diffuser(s) and/or refractive element(s) according to various embodiments of this invention.

It is noted that the color filters of the display panels discussed herein are referred to as red (R), green (G) and blue (B) colored filters/pixels. Likewise, R, G and B LEDs are discussed as light sources in backlights herein. However, it is noted that other colors may additionally, or instead, be used. For instance, cyan and/or white filters, pixels, and light sources are also possible in addition to or instead of red, green, and/or blue.

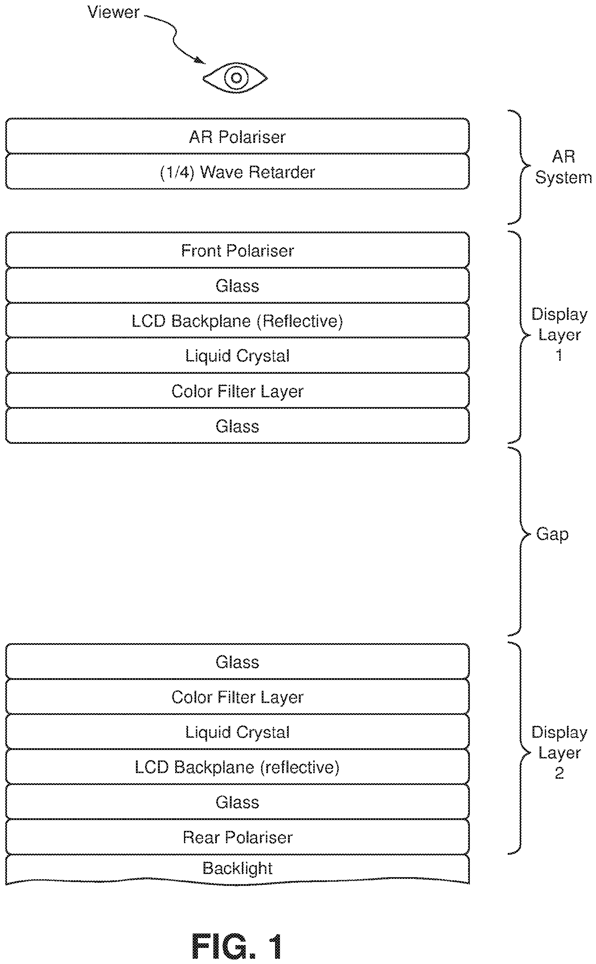

The MLD system shown in Figs. 1-2 has two overlapping and substantially parallel displays. The displays (or display layers, or display panels) of the MLD herein may be LCDs. Twisted nematic (TN) LCDs may follow a fairly generic pixel layout, such as a square divided into three portions running horizontally with red green and blue sub-pixels. The sub-pixels may be separated by a black mask in the horizontal and vertical directions. There is often a square protrusion in the corner of the sub-pixel to cover the drive transistor. There are several different types of pixel technology that enable wide screen viewing and temporal performance required for modern desktop monitors and televisions. Embodiments of the present invention are compatible with all of these LCDs, since the backplanes are designed to follow the basic RGB stripe pixel layout. As such, the backplane layout required for each pixel not need to change, only the color filter mask layout. For example, pixel types by manufacturer are: Panasonic (IPS Pro), LG Display (H-IPS & P-IPS), Hannstart (S-IPS), AU Optronics (A-MVA), Samsung (AFFS), S-LCD (S-PVA), and Sharp Corporation (ASV and MVA). IPS type LCDs, or other LCD types, may also be used.

Fig. 1 illustrates a MLD according to an example embodiment of this invention. Display or display layer 2 is closest to the backlight of the MLD, and it may be desirable to have its backplane facing the backlight system to recycle light that may pass through row drivers, column drivers, transistors, and storage capacitance lines into the backlight. A two polarizer configuration may be used, as shown in the figure, and gaps may be designed to include air or material having birefringence designed to maintain black state of the display when desired. The gap may include material having a refractive index matched closely to glass or the layers on either side to reduce internal reflection and/or depolarization effects. For the front display or display layer 1, its backplane may be oriented opposite to that of display or display layer 2. In particular, for the front display 1 its backplane may be oriented to face the viewer to reduce internal reflections. Thus, it can be seen in Fig. 1 that the color filter layers (each of which may be made up of one or more layers) of the respective displays 1 and 2 face each other, with no liquid crystal layer from either display being located between the color filter layers of the first and second displays. In certain example embodiments, to reduce external reflections of ambient light, there may be provided an antireflective system such as that shown in Fig. 1 made up of quarter wave retarder and an antireflective polarizer, so that ambient light that would normally be reflected would undergo a quarter wave rotation on the first pass through the AR polarizer, is reflected by the backplane elements, undergoes a second rotation through the quarter wavelength retarder. By the time it goes through this second rotation, it is substantially orthogonal to the transmission axis of the AR polarizer and thus will be substantially absorbed. Additionally, black mask (BM) or other non-reflective material may be added behind the conductive traces of the displays to reduce reflections. Additionally, antireflective (AR) coating(s) may be applied to the interior surfaces in certain example embodiments of this invention. As explained herein, the use of the vibration and selective backlight control to reduce moire interference may avoid the need for a diffuser to be provided in the gap between the two display panels of the MLD system.

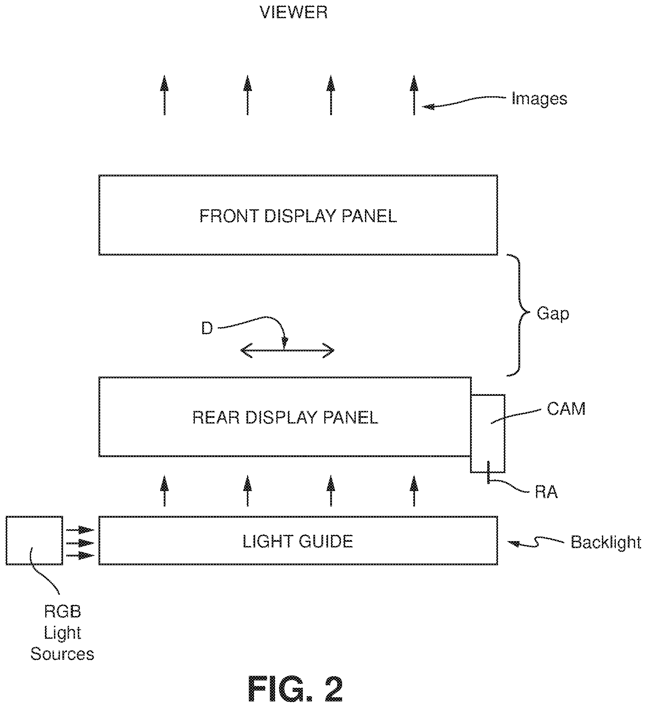

Fig. 2 is a schematic diagram, representative of the Fig. 1 MLD system or any other suitable or applicable MLD system having first and second overlapping display panels. As shown in Fig. 2, the MLD system includes first and second display panels that are arranged substantially parallel to each other with a gap (e.g., air gap, or gap filled with index matching material) therebetween. Each display panel may be an LCD, as discussed above. A backlight provided behind the rear panel includes a plurality of light sources (e.g., red, green, and blue LED light sources) which direct colored light into a light guide which redirects the light toward the two display panels as shown in Fig. 2. The backlight shown in Fig. 2 is an edge-mounted backlight, because the color LED light sources are provided along an edge(s) of the lightguide. Alternatively, an area array type of backlight could instead be used with colored light sources.

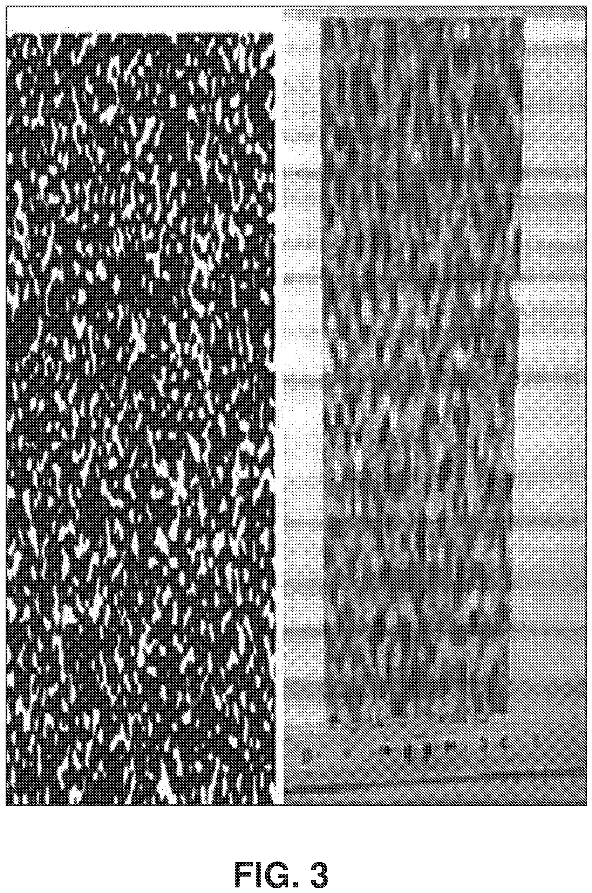

A movable (e.g., rotatable) cam, when moved (e.g., rotated), introduces panel vibration (e.g., Perlin noise) to the rear display panel thereby moving the rear display panel back and forth in direction D as shown in Fig. 2. The eccentric cam, for example, may be rotated about rotational axis/shaft RA in order to cause the rear panel to move back and forth in direction D. The cam may directly or indirectly abut the rear panel in various embodiments of this invention in order to impart such vibration to the rear panel. A biasing forced, such as via a spring (not shown), may be provided on the side of the panel opposite the cam in certain example embodiments effectively giving the cam a force against which to move the panel. Thus, it will be appreciated that the cam causes only one of the two display panels in the MLD system to vibrate (the other display panel is not vibrated). While an eccentric rotating cam, driven by a motor via rotating shaft RA, is shown as a vibrating device for vibrating one of the panels in Fig. 3, other types of vibrating devices (e.g., reciprocating cam, reciprocating ram, spring biasing member, etc.) may instead or in addition be used. Fig. 3 is a top view illustrating on the left a panel with no vibration, and on the right a panel being vibrated, in order to reduce moire interference in the MLD system of any embodiment herein. While Fig. 2 shows the rear display panel being vibrated, instead the front display panel may be vibrated in alternative embodiments of this invention.

Perlin noise is an example type of vibration that may be applied to one of the two display panels to reduce moire interference. Perlin noise is a type of gradient noise, and has a pseudo-random appearance. In certain embodiments, all visual details of Perlin noise may be the same size. In certain example instances, multiple scaled copies of Perlin noise can be used. While Perlin noise is an example type of vibration that may be used in certain embodiments herein, this invention is not so limited as other types of vibration may also be used.

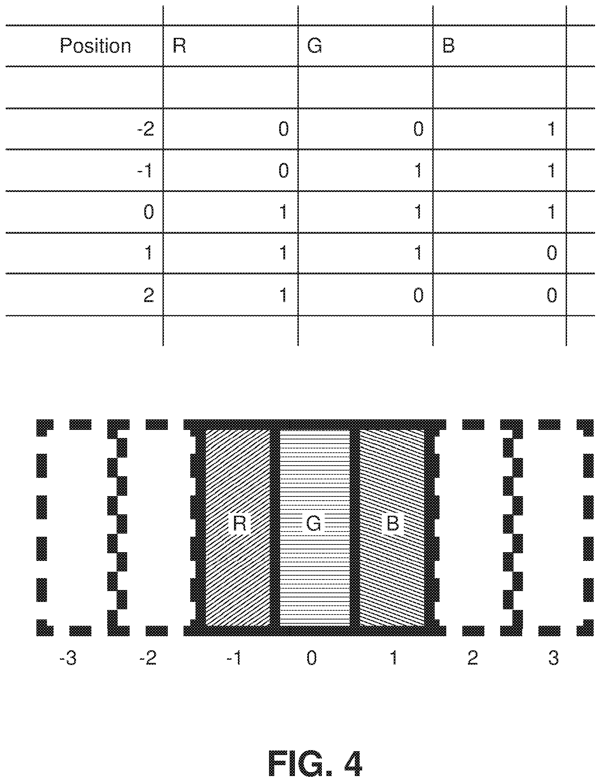

Referring to Fig. 4, selective backlight control is used in conjunction with panel vibration in order to reduce moire interference in order to improve image quality to viewer(s). Fig. 4 is a timing diagram, that when used allows one to be able to maintain a white pixel on a black background without any additional blurring. Red (R), green (G), and blue (B) subpixels, making up a pixel, are shown in Fig. 4. The color filters of the respective R, G and B subpixels are shown as parallel stripes in Fig. 4, although other shapes are possible for the color filters and/or subpixels. The subpixels in Fig. 4 are in the panel that is subject to the vibration discussed herein. In the three right-most columns in the upper portion of Fig. 4, a "0" is used to indicate that a particular color LED source in the backlight is turned off, and a "1" is used to indicated that a particular color LED source in the backlight is turned on. Thus, for example, at timing position -1, the red LED source(s) in the backlight are off while the green and blue LED sources in the backlight are on. As another example, at timing position -2, the red and green LED sources in the backlight are off while the blue LED source(s) in the backlight is on.

The green (G) pixel or subpixel is used, for example, in Fig. 4 to track the position of the panel. At timing position 0 (see green pixel in the center), the R, G and B LED sources in the backlight are all on. Then, when the green pixel or subpixel has moved either one or two sub-pixels to the right due to the vibration (see timing positions 1 and 2), the red LED source(s) in the backlight is on and the red will appear to cover the entire pixel. However, since the red LED source(s) in the backlight is turned off when the green pixel or sub-pixel moves one or two pixels to the left due to the vibration (see timing positions -1 and -2), the red sub-pixel will not appear to move beyond the LH boundary of the pixel. This prevents (or reduces) the viewer seeing a blurred pixel. However, from a moire standpoint, as shown in Fig. 4, when one can move the red sub-pixel stripe (e.g., red color filter pixel or subpixel) across the green and blue positions, and flash the red portion of the back-light on when in those positions, this will make the panel appear a uniform white when "fused" by the viewer's visual system. The same applies with blue, except in the opposite movement direction.

When the green (G) pixel or subpixel (the same could also be said for the R or B subpixels, because all the subpixels and pixels move together when the panel is vibrated such as with Perlin noise) has moved either one or two sub-pixels to the left due to the vibration (see timing positions -1 and -2), the blue LED source(s) in the backlight is on and the blue will appear to cover the entire pixel. However, since the blue LED source(s) in the backlight is turned off when the green pixel or sub-pixel moves one or two pixels to the right due to the vibration (see timing positions 1 and 2), the blue sub-pixel will not appear to move beyond the RH (righthand) boundary of the pixel. This prevents (or reduces) the viewer seeing a blurred pixel. Thus, from a moire standpoint, as shown in Fig. 4, when one can move the blue sub-pixel stripe (e.g., blue color filter pixel or subpixel) across the green and blue positions, and flash the blue portion of the back-light on when in those positions, this will make the panel appear a uniform white when "fused" by the viewer's visual system.

Accordingly, it can be seen that panel vibration and selective backlight control are used to reduce moire interference in a MLD system in embodiments of this invention.

While the foregoing disclosure sets forth various embodiments using specific block diagrams, flowcharts, and examples, each block diagram component, flowchart step, operation, and/or component described and/or illustrated herein may be implemented, individually and/or collectively, using a wide range of hardware, software, or firmware (or any combination thereof) configurations.

The process parameters and sequence of steps described and/or illustrated herein are given by way of example only and can be varied as desired without departing from the scope of the claims. For example, while the steps illustrated and/or described herein may be shown or discussed in a particular order, these steps do not necessarily need to be performed in the order illustrated or discussed.

The foregoing description, for purpose of explanation, has been described with reference to specific embodiments. However, the illustrative discussions above are not intended to be exhaustive or to limit the invention to the precise forms disclosed. Many modifications and variations are possible in view of the above teachings. The embodiments were chosen and described in order to best explain the principles of the invention and its practical applications, to thereby enable others skilled in the art to best utilize the invention and various embodiments with various modifications as may be suited to the particular use contemplated.

Moreover, the scope of the present invention is defined by the claims and is not intended to be limited to the particular embodiments.

## Claims

1. A display device comprising:
a first display panel in a first plane for displaying a first image;
a second display panel in a second plane for displaying a second image overlapping the first image, wherein said first and second planes are approximately parallel to each other;
a vibrator for mechanically vibrating one of the first and second display panels, but not the other of the first and second display panels, in order to reduce moiré interference, wherein the vibrator is for vibrating said one of the first and second display panels at least in a direction within the plane of said one panel; **characterized by**
a backlight including first, second, and third differently colored light sources,
wherein said first, second, and third differently colored light sources are each configured to be selectively controlled based on a position of said one of the first and second display panels with respect to the other display panel so as to reduce blurring of the image perceived by the viewer.

2. The display device of claim 1, wherein the vibrator comprises an eccentric cam configured to be driven by a motor.

3. The display device of any preceding claim, wherein the other of the first and second display panels is not configured to be vibrated.

4. The display device of claim 1, wherein one of the first, second and third differently colored light sources is a red colored light source which is configured to be turned on when a red colored subpixel of the display panel which is subjected to vibration is in a neutral position and when the red colored subpixel is shifted one and/or two subpixels to one side of the neutral position, but is configured to be turned off when the red colored subpixel is shifted to the other side of the neutral position.

5. The display device of claim 1, wherein one of the first, second and third differently colored light sources is a blue colored light source which is configured to be turned on when a blue colored subpixel of the display panel which is subjected to vibration is in a neutral position and when the blue colored subpixel is shifted one and/or two subpixels to one side of the neutral position, but is configured to be turned off when the blue colored subpixel is shifted to the other side of the neutral position.

6. The display device of any of claims 4-5, wherein red, green and blue colored light sources in the backlight are all configured to be turned on when the blue colored subpixel is in the neutral position.

7. The display device of any preceding claim, wherein the first and second display panels comprise liquid crystal displays.

8. The display device of any preceding claim, wherein said one of the first and second display panels is a rear display.

9. The display device of any preceding claim, wherein said one of the first and second display panels is a front display.

10. The display device of any preceding claim, wherein the vibrator is configured to vibrate said one of the first and second display panels in a manner so as to introduce Perlin noise to said one display panel.

11. A method for displaying images via a display apparatus, the method comprising:
providing a first display panel in a first plane displaying a first image;
providing a second display panel in a second plane displaying a second image overlapping the first image, wherein said first and second planes are approximately parallel to each other;
mechanically vibrating the first display panel at least in a direction within the plane of the first display panel in order to reduce moire interference; **characterized by**
selectively controlling first, second, and third differently colored light sources of a backlight of the display apparatus based at least on a position of said first display panel with respect to the second display panel so as to reduce blurring of the image perceived by the viewer.

12. The method of claim 11, further comprising turning on a red colored light source which is one of the first, second and third differently colored light sources in the backlight when a red colored subpixel in the first display is in a neutral position and when the red colored subpixel is shifted one and/or two subpixels to one side of the neutral position, and turning off the red colored light source when the red colored subpixel is shifted to the other side of the neutral position.

13. The method of any of claims 11-12, further comprising turning on a blue colored light source which is one of the first, second and third differently colored light sources in the backlight when a blue colored subpixel in the first display is in a neutral position and when the blue colored subpixel is shifted one and/or two subpixels to one side of the neutral position, and turning off the blue colored source when the blue colored subpixel is shifted to the other side of the neutral position.

14. The method of any of claims 11-13, wherein the second display is not vibrated when the first display is being vibrated.

15. The display device of claim 1, wherein the vibrator comprises a cam configured to be rotated about a rotational axis in order to cause the second display panel to move back and forth in a direction D in the plane of the panel, wherein the cam directly or indirectly abuts the second display panel in order to impart such vibration to the second display panel, and wherein a biasing spring is provided on a side of the second display panel opposite the cam in order to provide the cam a force against which to move the panel.

## Patentansprüche

1. Anzeigeeinrichtung, umfassend:
ein erstes Anzeigeelement in einer ersten Ebene zum Anzeigen eines ersten Bilds;
ein zweites Anzeigeelement in einer zweiten Ebene zum Anzeigen eines zweiten Bilds, das das erste Bild überlappt, wobei die erste und zweite Ebene ungefähr parallel zueinander sind;
eine Schwingungseinrichtung, um eines des ersten und zweiten Anzeigeelements, nicht jedoch das andere des ersten und zweiten Anzeigeelements, mechanisch schwingen zu lassen, um eine Moire-Interferenz zu reduzieren, wobei die Schwingungseinrichtung dazu dient, das eine des ersten und zweiten Anzeigeelements zumindest in einer Richtung innerhalb der Ebene des einen Elements schwingen zu lassen;
**gekennzeichnet durch**
eine Hintergrundbeleuchtung, die eine erste, eine zweite und eine dritte Lichtquelle unterschiedlicher Farben umfasst, wobei die erste, zweite und dritte Lichtquelle unterschiedlicher Farben jeweils ausgestaltet sind, um basierend auf einer Position des einen des ersten und zweiten Anzeigeelements in Bezug auf das andere Anzeigeelement selektiv gesteuert zu werden, um ein Verschwimmen des durch den Betrachter wahrgenommenen Bilds zu reduzieren.

2. Anzeigeeinrichtung nach Anspruch 1, wobei die Schwingungseinrichtung einen exzentrischen Nocken umfasst, der ausgestaltet ist, um durch einen Motor angetrieben zu werden.

3. Anzeigeeinrichtung nach einem der vorstehenden Ansprüche, wobei das andere des ersten und zweiten Anzeigeelements nicht ausgestaltet ist, um schwingen gelassen zu werden.

4. Anzeigeeinrichtung nach Anspruch 1, wobei eine der ersten, zweiten und dritten Lichtquelle unterschiedlicher Farben eine Lichtquelle roter Farbe ist, die ausgestaltet ist, um eingeschaltet zu werden, wenn sich ein Subpixel roter Farbe des Anzeigeelements, das einer Schwingung ausgesetzt ist, an einer neutralen Position befindet und wenn das Subpixel roter Farbe um ein und/oder zwei Subpixel auf eine Seite der neutralen Position verschoben wird, jedoch ausgestaltet ist, um ausgeschaltet zu werden, wenn das Subpixel roter Farbe auf die andere Seite der neutralen Position verschoben wird.

5. Anzeigeeinrichtung nach Anspruch 1, wobei eine der ersten, zweiten und dritten Lichtquelle unterschiedlicher Farben eine Lichtquelle blauer Farbe ist, die ausgestaltet ist, um eingeschaltet zu werden, wenn sich ein Subpixel blauer Farbe des Anzeigeelements, das einer Schwingung ausgesetzt ist, an einer neutralen Position befindet und wenn das Subpixel blauer Farbe um ein und/oder zwei Subpixel auf eine Seite der neutralen Position verschoben wird, jedoch ausgestaltet ist, um ausgeschaltet zu werden, wenn das Subpixel blauer Farbe auf die andere Seite der neutralen Position verschoben wird.

6. Anzeigeeinrichtung nach einem der Ansprüche 4-5, wobei die Lichtquellen roter, grüner und blauer Farbe in der Hintergrundbeleuchtung alle ausgestaltet sind, um eingeschaltet zu werden, wenn sich das Subpixel blauer Farbe an der neutralen Position befindet.

7. Anzeigeeinrichtung nach einem der vorstehenden Ansprüche, wobei das erste und zweite Anzeigeelement Flüssigkristallanzeigen umfassen.

8. Anzeigeeinrichtung nach einem der vorstehenden Ansprüche, wobei das eine des ersten und zweiten Anzeigeelements eine hintere Anzeige ist.

9. Anzeigeeinrichtung nach einem der vorstehenden Ansprüche, wobei das eine des ersten und zweiten Anzeigeelements eine vordere Anzeige ist.

10. Anzeigeeinrichtung nach einem der vorstehenden Ansprüche, wobei die Schwingungseinrichtung ausgestaltet ist, um das eine des ersten und zweiten Anzeigeelements in einer Weise schwingen zu lassen, um Perlin-Noise in das eine Anzeigeelement einzuführen.

11. Verfahren zum Anzeigen von Bildern über eine Anzeigevorrichtung, wobei das Verfahren umfasst, dass:
ein erstes Anzeigeelement in einer ersten Ebene bereitgestellt wird, das ein erstes Bild anzeigt;
ein zweites Anzeigeelement in einer zweiten Ebene bereitgestellt wird, das ein zweites Bild anzeigt, das das erste Bild überlappt, wobei
die erste und zweite Ebene ungefähr parallel zueinander sind;
das erste Anzeigeelement zumindest in einer Richtung innerhalb der Ebene des ersten Anzeigeelements mechanisch schwingen gelassen wird, um eine Moire-Interferenz zu reduzieren;
**dadurch gekennzeichnet, dass**
eine erste, eine zweite und eine dritte Lichtquelle unterschiedlicher Farben einer Hintergrundbeleuchtung der Anzeigevorrichtung basierend auf zumindest einer Position des ersten Anzeigeelements in Bezug auf das zweite Anzeigeelement selektiv gesteuert werden, um ein Verschwimmen des durch den Betrachter wahrgenommenen Bilds zu reduzieren.

12. Verfahren nach Anspruch 11, das ferner umfasst, dass eine Lichtquelle roter Farbe, die eine der ersten, zweiten und dritten Lichtquelle unterschiedlicher Farben in der Hintergrundbeleuchtung ist, eingeschaltet wird, wenn sich ein Subpixel roter Farbe in der ersten Anzeige an einer neutralen Position befindet und wenn das Subpixel roter Farbe um ein und/oder zwei Sub-pixel auf eine Seite der neutralen Position verschoben wird, und die Lichtquelle roter Farbe ausgeschaltet wird, wenn das Subpixel roter Farbe auf die andere Seite der neutralen Position verschoben wird.

13. Verfahren nach einem der Ansprüche 11-12, das ferner umfasst, dass eine Lichtquelle blauer Farbe, die eine der ersten, zweiten und dritten Lichtquelle unterschiedlicher Farben in der Hintergrundbeleuchtung ist, eingeschaltet wird, wenn sich ein Subpixel blauer Farbe in der ersten Anzeige an einer neutralen Position befindet und wenn das Subpixel blauer Farbe um ein und/oder zwei Subpixel auf eine Seite der neutralen Position verschoben wird, und die Quelle blauer Farbe ausgeschaltet wird, wenn das Subpixel blauer Farbe auf die andere Seite der neutralen Position verschoben wird.

14. Verfahren nach einem der Ansprüche 11-13, wobei die zweite Anzeige nicht schwingen gelassen wird, wenn die erste Anzeige schwingen gelassen wird.

15. Anzeigeeinrichtung nach Anspruch 1, wobei die Schwingungseinrichtung einen Nocken umfasst, der ausgestaltet ist, um um eine Drehachse gedreht zu werden, um zu bewirken, dass sich das zweite Anzeigeelement in einer Richtung D in der Ebene des Elements hin- und herbewegt, wobei der Nocken direkt oder indirekt an dem zweiten Anzeigeelement anliegt, um eine derartige Schwingung auf das zweite Anzeigeelement aufzubringen, und wobei eine Vorspannungsfeder auf einer Seite des zweiten Anzeigeelements gegenüber dem Nocken vorgesehen ist, um dem Nocken eine Kraft, gegen die das Element zu bewegen ist, bereitzustellen.

## Revendications

1. Dispositif d'affichage comprenant :
un premier panneau d'affichage dans un premier plan pour afficher une première image ;
un deuxième panneau d'affichage dans un deuxième plan pour afficher une deuxième image chevauchant la première image, dans lequel lesdits premier et deuxième plans sont approximativement parallèles l'un à l'autre ;
un vibrateur pour faire vibrer mécaniquement l'un des premier et deuxième panneaux d'affichage, mais pas l'autre des premier et deuxième panneaux d'affichage, afin de réduire l'interférence de moiré, dans lequel le vibrateur est destiné à faire vibrer ledit un des premier et deuxième panneaux d'affichage au moins dans une direction située dans le plan dudit un panneau ;
**caractérisé par**
un rétroéclairage incluant des première, deuxième et troisième sources lumineuses de couleurs différentes,
dans lequel lesdites première, deuxième et troisième sources lumineuses de couleurs différentes sont chacune configurées pour être commandées sélectivement sur la base d'une position dudit un des premier et deuxième panneaux d'affichage par rapport à l'autre panneau d'affichage de manière à réduire le flou de l'image perçue par l'observateur.

2. Dispositif d'affichage selon la revendication 1, dans lequel le vibrateur comprend une came excentrique configurée pour être entraînée par un moteur.

3. Dispositif d'affichage selon l'une quelconque des revendications précédentes, dans lequel l'autre des premier et deuxième panneaux d'affichage n'est pas configuré pour être mis en vibration.

4. Dispositif d'affichage selon la revendication 1, dans lequel l'une des première, deuxième et troisième sources lumineuses de couleurs différentes est une source lumineuse de couleur rouge qui est configurée pour être allumée lorsqu'un sous-pixel de couleur rouge du panneau d'affichage qui est soumis à une vibration est dans une position neutre et lorsque le sous-pixel de couleur rouge est décalé d'un et/ou deux sous-pixels vers un côté de la position neutre, mais est configurée pour être éteinte lorsque le sous-pixel de couleur rouge est décalé vers l'autre côté de la position neutre.

5. Dispositif d'affichage selon la revendication 1, dans lequel l'une des première, deuxième et troisième sources lumineuses de couleurs différentes est une source lumineuse de couleur bleue qui est configurée pour être allumée lorsqu'un sous-pixel de couleur bleue du panneau d'affichage qui est soumis à une vibration est dans une position neutre et lorsque le sous-pixel de couleur bleue est décalé d'un et/ou deux sous-pixels vers un côté de la position neutre, mais est configurée pour être éteinte lorsque le sous-pixel de couleur bleue est décalé vers l'autre côté de la position neutre.

6. Dispositif d'affichage selon l'une quelconque des revendications 4 à 5, dans lequel des sources lumineuses de couleur rouge, verte et bleue dans le rétroéclairage sont toutes configurées pour être allumées lorsque le sous-pixel de couleur bleue est dans la position neutre.

7. Dispositif d'affichage selon l'une quelconque des revendications précédentes, dans lequel les premier et deuxième panneaux d'affichage comprennent des afficheurs à cristaux liquides.

8. Dispositif d'affichage selon l'une quelconque des revendications précédentes, dans lequel ledit un des premier et deuxième panneaux d'affichage est un afficheur arrière.

9. Dispositif d'affichage selon l'une quelconque des revendications précédentes, dans lequel ledit un des premier et deuxième panneaux d'affichage est un afficheur avant.

10. Dispositif d'affichage selon l'une quelconque des revendications précédentes, dans lequel le vibrateur est configuré pour faire vibrer ledit un des premier et deuxième panneaux d'affichage de manière à introduire un bruit de Perlin dans ledit un panneau d'affichage.

11. Procédé pour afficher des images au moyen d'un appareil d'affichage, le procédé comprenant les étapes consistant à :
fournir un premier panneau d'affichage dans un premier plan affichant une première image ;
fournir un deuxième panneau d'affichage dans un deuxième plan affichant une deuxième image chevauchant la première image, dans lequel lesdits premier et deuxième plans sont approximativement parallèles l'un à l'autre ;
faire vibrer mécaniquement le premier panneau d'affichage au moins dans une direction située dans le plan du premier panneau d'affichage afin de réduire l'interférence de moiré ;
**caractérisé par** l'étape consistant à
commander sélectivement des première, deuxième et troisième sources lumineuses de couleurs différentes d'un rétroéclairage de l'appareil d'affichage sur la base d'au moins une position dudit premier panneau d'affichage par rapport au deuxième panneau d'affichage de manière à réduire le flou de l'image perçue par l'observateur.

12. Procédé selon la revendication 11, consistant en outre à allumer une source lumineuse de couleur rouge qui est l'une des première, deuxième et troisième sources lumineuses de couleurs différentes dans le rétroéclairage lorsqu'un sous-pixel de couleur rouge dans le premier afficheur est dans une position neutre et lorsque le sous-pixel de couleur rouge est décalé d'un et/ou deux sous-pixels vers un côté de la position neutre, et à éteindre la source lumineuse de couleur rouge lorsque le sous-pixel de couleur rouge est décalé vers l'autre côté de la position neutre.

13. Procédé selon l'une quelconque des revendications 11 à 12, consistant en outre à allumer une source lumineuse de couleur bleue qui est l'une des première, deuxième et troisième sources lumineuses de couleurs différentes dans le rétroéclairage lorsqu'un sous-pixel de couleur bleue dans le premier afficheur est dans une position neutre et lorsque le sous-pixel de couleur bleue est décalé d'un et/ou deux sous-pixels vers un côté de la position neutre, et à éteindre la source de couleur bleue lorsque le sous-pixel de couleur bleue est décalé vers l'autre côté de la position neutre.

14. Procédé selon l'une quelconque des revendications 11 à 13, dans lequel le deuxième afficheur n'est pas mis en vibration lorsque le premier affichage est mis en vibration.

15. Dispositif d'affichage selon la revendication 1, dans lequel le vibrateur comprend une came configurée pour être tournée autour d'un axe de rotation afin d'amener le deuxième panneau d'affichage à se déplacer en avant en en arrière dans une direction D dans le plan du panneau, dans lequel la came vient directement ou indirectement en butée contre le deuxième panneau d'affichage afin de communiquer une telle vibration au deuxième panneau d'affichage, et dans lequel un ressort de sollicitation est prévu sur un côté du deuxième panneau d'affichage opposé à la came afin de fournir à la came une force contre laquelle déplacer le panneau.
